# EUROPÄISCHE PATENTSCHRIFT

(11) **EP 1 470 595 B1**
(45) Veröffentlichungstag und Bekanntmachung des Hinweises auf die Patenterteilung: **26.10.2005**
(21) Anmeldenummer: 03706272.6
(22) Anmeldetag: 30.01.2003
(51) Int. Cl.: H01L 41/24, F02M 51/06

(54) **VERFAHREN ZUM VORBEHANDELN EINER PIEZOELEKTRISCHEN KERAMIK UND VERFAHREN ZUM JUSTIEREN EINES EINSPRITZVENTILS**
METHOD FOR PRETREATING A PIEZOELECTRIC CERAMIC AND METHOD FOR ADJUSTING AN INJECTION VALVE
PROCEDE DE PRETRAITEMENT D'UNE CERAMIQUE PIEZOELECTRIQUE ET PROCEDE D'AJUSTAGE D'UNE SOUPAPE D'INJECTION

(30) Priorität: 01.02.2002 DE 10204047
(43) Veröffentlichungstag der Anmeldung: 27.10.2004
(73) Patentinhaber: SIEMENS AKTIENGESELLSCHAFT, 80333 München (DE)
(72) Erfinder: VOIGT, Andreas, 93055 Regensburg (DE); GOLLER, Matthias, 93077 Bad Abbach (DE); KOHN, Stefan, 92277 Hohenburg (DE); REISINGER, Wolfgang, 93053 Regensburg (DE); ZUMSTRULL, Claus, 93128 Regenstauf (DE)
(86) Internationale Anmeldenummer: PCT/DE2003/000262
(87) Internationale Veröffentlichungsnummer: WO 2003/065468

(56) Entgegenhaltungen:
- EP-A- 0 485 995
- WO-A-01/23736
- WO-A-99/31739
- DE-A- 1 646 551
- DE-A- 10 028 335
- DE-A- 10 039 641
- DE-A- 19 619 319
- DE-C- 19 902 807
- PATENT ABSTRACTS OF JAPAN vol. 018, no. 464 (E-1598), 29. August 1994 (1994-08-29) & JP 06 151996 A (NEC CORP), 31. Mai 1994 (1994-05-31) -& JP 06 151996 A (NEC CORP) 31. Mai 1994 (1994-05-31)

## Beschreibung

Die Erfindung betrifft ein Verfahren zum Vorbehandeln einer piezoelektrischen Keramik gemäß dem Oberbegriff des Patentanspruchs 1.

Piezoelektrische Aktoren werden in den verschiedensten Bereichen der Technik eingesetzt. Insbesondere werden in modernen Einspritzventilen piezoelektrische Aktoren verwendet, um Stellglieder des Einspritzventiles zu betätigen. Durch die Betätigung des Stellgliedes wird beispielsweise ein Einspritzvorgang begonnen und/oder beendet.

Piezoelektrische Keramiken bestehen beispielsweise aus Bleizirkonat-Titanat-Keramiken und weisen aufgrund ihres piezoelektrischen Effektes den Vorteil auf, dass die piezoelektrische Keramik bei Beaufschlagung mit einer Spannung ihre Länge schnell um eine festgelegte Strecke verändert. Insbesondere die Schnelligkeit und die hohen Kräfte machen die piezoelektrische Keramik für den Einsatz bei Einspritzventilen interessant.

Es hat sich jedoch gezeigt, dass die piezoelektrischen Keramiken ihre Länge im nicht bestromten Zustand im Laufe der Zeit ändern. Somit ist es beispielsweise bei Einspritzventilen erforderlich, ein Spiel zwischen dem piezoelektrischen Aktor und dem Stellglied nach einer festgelegten Betriebsdauer neu zu justieren.

Aus dem Abstract der japanischen Patentanmeldung JP 06-151996 A ist ein Verfahren zur Vorbehandlung einer piezoelektrischen Keramik bekannt, bei der die piezoelektrische Keramik einer Temperatur bei der Polarisierung ausgesetzt wird, die größer als die Curie-Temperatur ist. Direkt nach der Temperaturbehandlung wird eine Gleichspannung angelegt und die Polarisierung der piezoelektrischen Keramik durchgeführt.

Aus der europäischen Patentanmeldung EP 0 485 995 A1 ist ein Verfahren zum Vorbehandeln einer piezoelektrischen Keramik bekannt, bei dem die Keramik einer Temperaturbehandlung bei 150°C bis 170°C für eine vorgegebene Zeitdauer unterzogen wird. Die Temperatur liegt dabei über der Curie-Temperatur der piezoelektrischen Keramik. Nach der Temperaturbehandlung wird die piezoelektrische Keramik mit einer Gleichspannung von 50 bis 150 V polarisiert.

Aus der deutschen Offenlegungsschrift DE 1 646 551 ist ein Verfahren zur Alterung elektrostriktiver keramischer Massen bekannt. Dabei wird das elektrostriktive keramische Element in einem abgeschlossenen Behälter, in dem ein Unterdruck herrscht, für eine gewisse Zeitspanne auf einer Temperatur gehalten. Die Temperatur ist höher als Zimmertemperatur. Zudem wird in dem Behälter Sauerstoff unter Atmosphärendruck geführt und die Sauerstoffatmosphäre über eine Zeitspanne aufrecht erhalten.

Aus der deutschen Offenlegungsschrift DE 100 39 641 A1 ist ein Verfahren zur Polarisationsbehandlung eines piezoelektrischen Körpers bekannt. Dabei wird eine Gleichspannung an den piezoelektrischen Körper für die Polarisationsbehandlung in Luft und in einer Atmosphäre mit einer Temperatur, die gleich oder höher als eine Alterungstemperatur ist, angelegt. Der Polarisationsgrad wird anhand der Frequenzeigenschaft während der Polarisation des piezoelektrischen Körpers ermittelt. Das Anliegen der Gleichspannung wird zu einem Zeitpunkt unterbrochen, zu dem der gemessene Polarisationsgrad einen festgelegten Wert erreicht. Der festgelegte Wert wird anhand einer Korrelation zwischen dem unmittelbar vor dem Unterbrechen des Anliegens der Gleichspannung erhaltenen Polarisationsgrad und dem nach dem Altern und dem Rückführen auf eine gewöhnliche Temperatur im Anschluss an das Unterbrechen des Anliegens der Spannung erhaltenen stabilen Polarisationsgrad ermittelt.

Aus der internationalen Patentanmeldung WO 99/31739 ist ein Verfahren zum Polarisieren eines piezoelektrischen Bauelements bekannt. Das piezoelektrische Bauelement weist eine Vielzahl von Piezokeramikschichten und dazwischenliegenden Metallelektroden auf. Bei der Polarisierung wird eine Druckspannung an das Bauelement vor Beginn der Polarisierung und bis zum Ende der Polarisierung angelegt. Die Druckspannung wirkt der verlängernden Wirkung des anzulegenden elektrischen Polarisationsfeldes entgegen. Während die Druckspannung am Bauelement anliegt, wird ein elektrisches Polarisationsfeld an das Bauelement angelegt, wobei die angelegte Feldstärke größer ist als die Koerzitivfeldstärke des Bauelements. Die Polarisation wird bei einer Temperatur von 20 bis 150°C durchgeführt.

Aus der internationalen Patentanmeldung WO 01/23736 A1 ist ein gattungsgemäßes Verfahren zum Vorbehandeln einer piezoelektrischen Keramik gemäß dem Oberbegriff des Patentanspruchs 1 bekannt. Bei dem bekannten Verfahren wird die piezoelektrische Keramik einer Temperaturbehandlung unterzogen, wobei die Temperaturbehandlung in bei einer Temperatur von 50 bis 150°C durchgeführt wird. Während der Temperaturbehandlung wird die Keramik einem Polungsvorgang mit gepulster Gleichspannung unterzogen. Dabei wird eine elektrische Pulsfolge mit einer Frequenz von 55 Hz während einer Ansteuerzeit von einer Millisekunde eingesetzt.

Die Aufgabe der Erfindung besteht darin, ein Verfahren zum Vorbehandeln einer piezoelektrischen Keramik bereitzustellen, bei dem eine längere Stabilität der Länge der Keramik gegeben ist.

Weiterhin besteht die Aufgabe der Erfindung darin, ein Verfahren zur Justierung eines Einspritzventils bereitzustellen, nach dessen Durchführung eine Neujustierung des piezoelektrischen Aktors in Bezug auf ein zugeordnetes Stellglied erst nach einer längeren Betriebsdauer erforderlich ist.

Die Aufgaben der Erfindung werden durch das Verfahren gemäß den Merkmalen des Anspruchs 1 und durch das Verfahren gemäß den Merkmalen des Anspruchs 11 gelöst.

Ein Vorteil der Erfindung gemäß dem Verfahren nach Anspruch 1 besteht darin, dass die Langzeitstabilität der Länge der Keramik durch eine Temperaturbehandlung verbessert wird, wobei die Temperatur im Bereich von 60 bis 200°C für eine vorgegebene Zeitdauer liegt. Versuche haben gezeigt, dass durch die Temperaturbehandlung die Langzeitstabilität der Länge der Keramik erhöht wird.

Mit einem Polungsvorgang während der Temperaturbehandlung wird eine Ausrichtung der elektrischen Orientierung der keramischen Mikrostruktur erreicht, wobei ein elektrisches Feld an die Keramik angelegt wird, das größer als die Koerzitivfeldstärke der Keramik ist.

Vorzugsweise wird die Temperaturbehandlung während einer Zeitdauer von 0,5 bis 2,5 Stunden durchgeführt.

Gute Ergebnisse haben sich bei einem Verfahren gezeigt, bei dem die Temperatur im Bereich von 60 bis 180°C liegt.

Weiterhin hat es sich als vorteilhaft erwiesen, die Keramik während der Temperaturbehandlung mechanisch vorzuspannen. Auch die Einwirkung einer mechanischen Spannung bewirkt eine Erhöhung der Langzeitstabilität der Länge der Keramik.

Erfindungsgemäß wird die Keramik während der Temperaturbehandlung elektrisch gepolt. Vorzugsweise wird die Polung mit einer Spannung von 50 bis 170 Volt durchgeführt. Weiterhin ergibt die Polung mit einer gepulsten Gleichspannung ebenfalls positive Effekte auf die Langzeitstabilität der Länge der Keramik. Dabei haben sich Frequenzen im Bereich von 20 bis 120 Hz als vorteilhaft erwiesen.

Gute Ergebnisse werden erreicht, wenn die Polung im Zeitraum von 50 bis 51 Sekunden durchgeführt wird.

Erfindungsgemäß wird bei der Polung die Spannung in einer Rampe mit zunehmender Spannung bis auf einen Maximalwert hochgefahren und die Maximalspannung für eine festgelegte Zeitdauer konstant gehalten. Auch diese Maßnahme wirkt sich vorteilhaft auf die Langzeitstabilität der Länge der piezoelektrischen Keramik aus.

Ein wesentlicher Vorteil des Verfahrens gemäß Anspruch 8 besteht darin, dass die erfindungsgemäß vorbehandelte piezoelektrische Keramik in Form eines piezoelektrischen Aktors in einem Einspritzventil verbaut ist, dass der Aktor auf eine definierte Lage oder Vorspannung in Bezug auf ein dem Aktor zugeordnetes Stellglied justiert ist und dass das Einspritzventil in einer Justierphase wenigstens mit einem Parameter betrieben wird, der einem Parameter entspricht, der bei einem normalen Betrieb der Brennkraftmaschine auftritt. Nach der Justierphase wird der Aktor erneut auf die definierte Lage oder Vorspannung justiert. Somit wird vor Inbetriebnahme des Einspritzventiles eine Justierung des Aktors erreicht, mit der die Langzeitstabilität der Justierung gewährleistet ist. Durch die Justierphase wird ein alterungsbedingter Setzvorgang, bei dem sich die Keramik verkürzt, vorgezogen. Durch die Justierphase wird die Keramik vorzugsweise in ein Gleichgewicht gebracht, das den späteren Betriebsbedingungen entspricht. Damit werden zeitlich auftretende Längenänderungen der piezoelektrischen Keramik vorweggenommen. Somit ist das Einspritzventil für einen längere Betriebsdauer optimal justiert.

Ein besonders einfaches Justierverfahren wird dadurch erreicht, dass das Einspritzventil in einer Brennkraftmaschine eingebaut wird, und dass das Einspritzventil in der Justierphase zum Einspritzen von Kraftstoff verwendet wird. Somit wird das Einspritzventil in der Umgebung und bei den Betriebsparametern justiert, die auch dem späteren Betrieb des Einspritzventils entsprechen. Somit kann eine optimale Anpassung an Parameter und die späteren Umgebungsbedingungen erreicht werden. Zudem ist es nicht erforderlich, einen speziellen Justieraufbau vorzusehen. Jede handelsübliche Brennkraftmaschine kann dazu verwendet werden.

In einer bevorzugten Ausführungsform steht das Einspritzventil mit einem Kraftstoffspeicher in Verbindung und der Kraftstoffspeicher hält Kraftstoff mit einem vorgebbaren Druck zum Einspritzen für das Einspritzventil bereit. Somit wird auch der Einfluss des Kraftstoffdruckes bei der Justierphase berücksichtigt. Vorzugsweise wird der Kraftstoff bei einem Druck bereitgehalten, der bei einem gewöhnlichen Betrieb der Brennkraftmaschine im Bereich des Maximaldruckes liegt. Moderne Common-Rail-Einspritzsysteme weisen maximale Kraftstoffdrücke im Bereich von 1400 bis 2000 bar auf. Durch die Verwendung des Maximaldruckes wird eine sehr hohe Beanspruchung der Keramik erreicht. Beispielsweise öffnet der Aktor ein Schließglied gegen den Druck des Kraftstoffes.

Vorzugsweise wird die Brennkraftmaschine mit einer Temperatur betrieben, die insbesondere im Bereich der piezoelektrischen Keramik in einem mittleren bis oberen Temperaturbereich liegt, der beim Betrieb der Brennkraftmaschine auftreten kann. Somit wird auch der Einfluss der Temperatur, der während des Betriebes der Brennkraftmaschine auf die Keramik einwirkt, bei der Justierphase berücksichtigt. Auch dies trägt zur Langzeitstabilität der Länge der Keramik bei.

Die Erfindung wird im Folgenden anhand der Figuren näher erläutert. Es zeigen
- Fig. 1: eine schematische Darstellung einer piezoelektrischen Keramik,
- Fig. 2: polare Strukturen einer Piezokeramik vor und nach der Polung.,
- Fig. 3: eine Einspritzvorrichtung mit einer Brennkraftmaschine und
- Fig. 4: einen Querschnitt durch einen Teil eines Einspritzventils,
- Fig. 5: eine Spannungsrampe für einen Polvorgang.

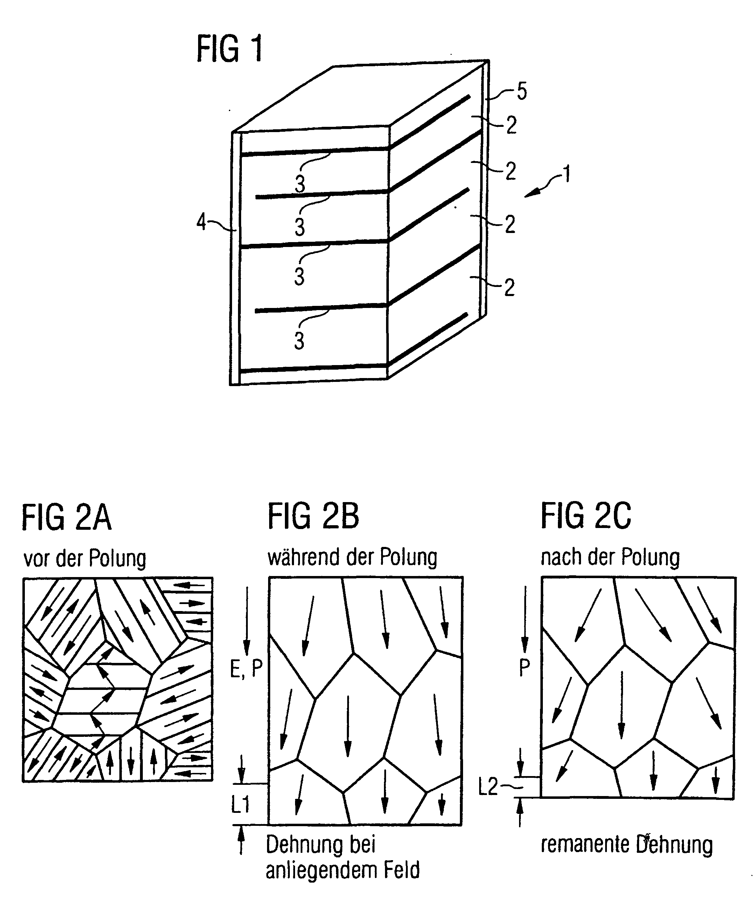

Fig. 1 zeigt eine piezoelektrische Keramik 1, die in Form von gestapelten Keramikschichten 2 aufgebaut ist. Die Keramikschichten 2 sind voneinander durch eine elektrisch leitende Ebene 3 getrennt. Zur Ausbildung der elektrisch leitenden Ebenen 3 werden Schichten verwendet, die beispielsweise aus Silber bestehen. Die Ebenen 3 werden in Form eines Siebdruckes aus pastenförmigen Silberpräparaten aufgebracht. Nach der Herstellung des piezokeramischen Stapels, der aus den Keramikschichten 2 und den elektrisch leitenden Ebenen 3 besteht, wird der Stapel einem Einbrennvorgang von 500 bis 800°C unterzogen. Dabei entsteht aus der Silberverbindung metallisches Silber, das nach einem Abkühlen des Piezostapels eine feste Verbindung mit der Piezokeramikunterlage herstellt. Die Ebenen 3 sind jeweils abwechselnd mit einem ersten oder zweiten Leitungsband 4, 5 verbunden. Die Leitungsbänder 4, 5 sind an diametral angeordneten Eckbereichen der im Querschnitt quadratisch ausgebildeten Piezokeramik 1 angeordnet. Die Leitungsbänder 4, 5 werden zum Aktivieren der Keramik mit unterschiedlicher Spannung versorgt, so dass zwischen zwei benachbarten Ebenen 3 sich jeweils ein elektrisches Feld ausbildet. Das elektrische Feld führt zur Deformation der Keramikschicht 2. Die Deformationen der Keramikschichten 2 addieren sich und führen somit zu einer Veränderung der Länge der piezoelektrischen Keramik 1. Die Deformationsänderung der Keramikschicht 2 ist proportional zur elektrischen Feldstärke, die auf die Keramikschicht 2 einwirkt.

Piezoelektrische Keramiken sind spezielle Ferroelektrika, deren Verhalten im elektrischen Feld die Piezoelektrizität bedingt. Zur Herstellung der Keramikschichten 2 eignen sich beispielsweise Bleizirkonat-Titanat-Keramiken (Pb(Ti, Zr)O₃). Die Polarisationseffekte in ferroelektrischer Keramik ergeben sich aus den Besonderheiten der keramischen Mikrostruktur bei Auftreten einer spontanen Polarisation. Als Ergebnis des Herstellungsprozesses, der beispielsweise in Form eines Sinterprozesses ausgebildet ist, ist jedes kristalline Korn der Keramikschicht 2 von anderen Körnern umgeben. Bei der Temperatur der Umwandlung in den ferroelektrischen Zustand wird jedes Korn infolge elektrostriktiver Effekte spontan in entsprechender Weise wie ein Einkristall deformiert. Dabei wird jedoch jedes Korn durch benachbarte Körner behindert, so dass innere Spannungen teilweise nur durch Aufspaltung eines Kornes in Domänen abgebaut werden können. Die Mikrostruktur der ferroelektrischen Keramik ist nach der Synthese und Abkühlung unter die Curie-Temperatur noch isotrop. D.h., dass die Dipolmomente der Körner aufgrund der statistischen Verteilung der Polarisationsrichtungen kompensiert sind. Dieser Zustand ist in Fig. 2A dargestellt.

Zur Herstellung einer piezoelektrischen Keramik wird die Keramik einem Polungsvorgang unterzogen. Der Polungsvorgang dient der Einstellung einer remanenten Polarisation der Keramik. Bei der Polarisation wird ein großes elektrisches Gleichfeld angelegt. Die elektrische Feldstärke muss dabei oberhalb einer Koerzitivfeldstärke des Keramikmaterials der Keramikschicht 2 liegen. In dem bis dahin isotropen Material erfolgt eine weitgehende Orientierung der ferroelektrischen Domänen, wie in Fig. 2B dargestellt ist.

Für unterschiedliche Zusammensetzungen kann die erforderliche Feldstärke sehr unterschiedlich sein. Der Wert hängt von der Beweglichkeit der ferroelektrischen Domänen ab, d.h. wie leicht die ferroelektrischen Domänen auszurichten sind. Mit steigender Temperatur verringert sich generell die erforderliche Polungsfeldstärke und die Polung verläuft mehr oder weniger in Abhängigkeit von der Einwirkungsdauer des elektrischen Feldes. Fig. 2B zeigt schematisch eine Keramikschicht 2 während des Polungsvorganges. Dabei dehnt sich die Keramikschicht 2 um eine erste Länge L1 aus. Zudem werden die Dipolmomente der ferroelektrischen Domänen ausgerichtet. Nach dem Ende des Polungsvorganges verkürzt sich die Länge der Keramik, bleibt jedoch um eine zweite Länge L2 länger als vor dem Polungsvorgang. Dieser Zustand ist in Fig. 2C dargestellt. Somit verbleibt eine remanente Polarisation der Keramik. Die remanente Polarisation, die die Länge der gepolten Keramik und die piezoelektrischen Effekte beeinflusst, nimmt mit der Zeit ab. Die Polarisation bestimmt die piezoelektrischen, elastischen oder dielektrischen Eigenschaften der Keramikschicht.

Die erfindungsgemäßen Verfahren führen dazu, die remanente Polarisation auf einen Wert zu bringen, der eine größere Langzeitstabilität aufweist. Dabei wird in Kauf genommen, dass sich die Keramik 1 evtl. weiter verkürzt oder auch veränderte piezoelektrische, elastische oder dielektrische Eigenschaften aufweist.

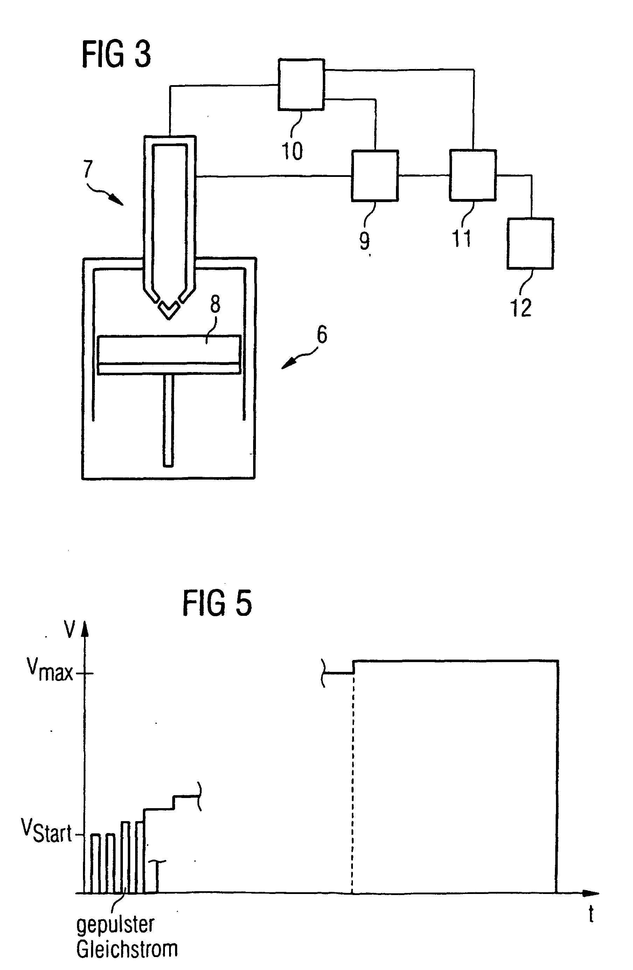

Fig. 3 zeigt eine schematische Darstellung einer Brennkraftmaschine 6, der ein Einspritzventil 7 zugeordnet ist. Das Einspritzventil 7 ragt in einen Brennraum eines Zylinders, der von einem beweglichen Kolben 8 abgedichtet wird. Das Einspritzventil 7 steht über eine Kraftstoffleitung mit einem Kraftstoffspeicher 9 in Verbindung, der Kraftstoff unter einem vorgegebenen Druck zum Einspritzen für das Einspritzventil 7 bereithält. Das Einspritzventil 7 ist über eine Steuerleitung mit einem Steuergerät 10 verbunden. Das Steuergerät 10 ist zudem über eine zweite Steuerleitung mit einem Regelventil des Kraftstoffspeichers 9 verbunden. Weiterhin steht das Steuergerät 10 vorzugsweise über eine dritte Steuerleitung mit einer Pumpe 11 in Verbindung, die Kraftstoff aus einem Tank 12 unter hohem Druck dem Kraftstoffspeicher 9 zuführt. Zum Einspritzen von Kraftstoff wird das Einspritzventil 7 vom Steuergerät 10 angesteuert. Dazu erfasst das Steuergerät 10 Betriebsparameter der Brennkraftmaschine, insbesondere die Last und/oder die Drehzahl.

Das Steuergerät 10 verfügt über einen Speicher, in dem Steuerprogramme zum Ansteuern des Einspritzventils abgelegt sind. Weiterhin sind Programme abgelegt, die das Einstellen des Kraftstoffdruckes im Kraftstoffspeicher 9 entweder über ein Druckregelventil des Kraftstoffspeichers 9 oder über eine Regelung der Förderleistung der Pumpe 11 steuern.

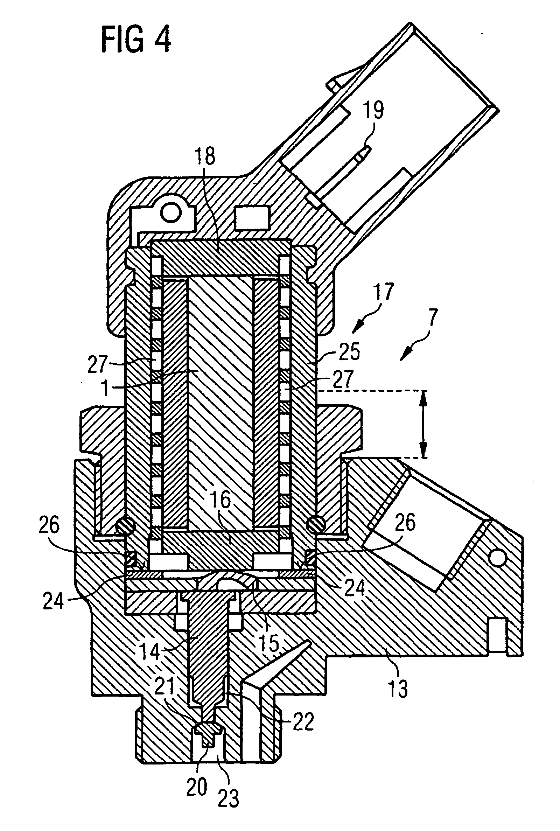

Fig. 4 zeigt einen Ausschnitt des Einspritzventils 7, das ein Gehäuse 13 zeigt, in dem ein Stellglied 14 beweglich angeordnet ist. Das Stellglied 14 steht über einen einseitig gelagerten Hebel 15 in Wirkverbindung mit einer Aktorplatte 16 des piezoelektrischen Aktors 17. Der Aktor 17 besteht im Wesentlichen aus der Keramik 1, die zwischen der Aktorplatte 16 und einer Kopfplatte 18 eingespannt ist. Die Kopfplatte 18 und der Aktor 17 sind über eine hülsenförmige Rohrfeder 27 gegeneinander vorgespannt. Auf diese Weise wird die Keramik 1 einer mechanischen Vorspannung unterzogen. Die Enden der Keramik 1 werden durch die Aktorplatte 16 und die Kopfplatte 18 mit einer festgelegten Vorspannkraft zusammengedrückt. Die Kopfplatte 18 ist fest mit einem oberen Endbereich eines Aktorgehäuses 25 verbunden, in das Aktor 17 eingebracht ist.

Das Aktorgehäuse 25 ist über eine Schraubverbindung mit dem Gehäuse 13 verschraubt. Auf einer Auflagefläche des Gehäuses 13 liegt der Hebel 15 mit einem Endbereich auf. Der andere Endbereich des Hebels 15 liegt auf einer Aufliegefläche des Stellgliedes 14 auf. Eine Auflagefläche des Hebels 15 ist der Aktorplatte 16 zugeordnet. Zwischen der Auflagefläche des Hebels 15 und der Aktorplatte ist vorzugsweise ein Abstand, ein sogenanntes Spiel ausgebildet. Je nach Ausführungsform kann auch die Aktorplatte mit einer gewünschten Vorspannung auf den Hebel und damit auf das Stellglied 14 vorgespannt sein.

Die Leitungsbänder 4, 5 (Fig.1) der Keramik 1 sind über elektrische Leitungen 19 mit dem Steuergerät 10 verbunden. Das Steuergerät 10 stellt durch eine entsprechende Bestromung der elektrischen Leitungen 19 die Länge der piezoelektrischen Keramik und damit die Position der Aktorplatte 16 ein. Somit verändert bei einer Bestromung der Keramik 1 die Aktorplatte 16 ihre Position gegenüber dem Hebel 15. Damit wird in Abhängigkeit von der Auslenkung der Keramik 1 der Hebel 15 nach unten auf das Stellglied 14 gedrückt. Dadurch wird auch das Stellglied 14 nach unten gedrückt.

In diesem Ausführungsbeispiel ist das Stellglied 14 einem Schließglied 20 zugeordnet. Das Schließglied 20 wird durch das Stellglied 14 bei Bestromung der Keramik 1 von einem zugeordneten Dichtsitz 21 abgehoben. Als Folge davon wird ein Abfluss 22 mit einer Steuerkammer 23 verbunden. Der Druck in der Steuerkammer 23 wirkt auf eine Einspritznadel ein. Der Druck in der Steuerkammer 23 spannt die Einspritznadel auf einen Nadelsitz vor. Weiterhin wird die Einspritznadel über Druckflächen mit dem gleichen Kraftstoffdruck beaufschlagt, der jedoch die Einspritznadel vom Nadelsitz abheben will. Wird folglich das Schließglied 20 über eine Betätigung des Stellgliedes 14 vom Dichtsitz 21 abgehoben, so sinkt der Druck in der Steuerkammer 23 und die Einspritznadel wird von dem weiterhin auf die Druckflächen einwirkenden Kraftstoffdruck vom Dichtsitz abgehoben. Folglich beginnt eine Einspritzung von Kraftstoff in den Brennraum der Brennkraftmaschine 6. Wird die Keramik entstromt, so verkürzt sich die Keramik 1. Folglich übt der Aktor 17 keine Kraft mehr auf das Stellglied 14 und das Schließglied 20 aus. Die Folge ist, dass das Schließglied 20 vom Kraftstoffdruck der Steuerkammer 23 wieder auf den Dichtsitz 21 gedrückt wird. Damit wird der Abfluß 22 verschlossen. Der Druck in der Steuerkammer 23 steigt wieder und die Einspritznadel 7 wird auf den Nadelsitz gedrückt. Damit wird die Einspritzung von Kraftstoff in den Brennraum beendet.

Der Abstand zwischen der Aktorplatte 16 und dem Hebel 15 wird durch die Einschraubtiefe des Aktorgehäuses 25 festgelegt. Zwischen einer Aufliegefläche 26 des Aktorgehäuses und dem Gehäuse 13 ist eine Einstellscheibe 24 eingebracht, die einen Sollabstand, d.h. ein Spiel, oder eine definierte Vorspannung zwischen der Aktorplatte 16 und dem Hebel 15 festlegt. Durch die Wahl der Dicke der Einstellscheibe 24 wird zugleich das Spiel oder die Vorspannung zwischen dem piezoelektrischen Aktor und dem Stellglied 14 festgelegt.

Tritt nun aufgrund von Alterungserscheinungen eine Verkürzung der Keramik 1 auf, so ist eine Neujustierung der Aktorplatte 16 in bezug auf den Hebel 15 bzw. das Stellglied 14 erforderlich. Dazu kann beispielsweise eine dickere oder dünnere Einstellscheibe 24 eingelegt werden und das Aktorgehäuse 25 auf den entsprechenden Abstand zum Gehäuse 13 eingeschraubt werden. Eine geringe Änderung des Spiels oder der Vorspannung wird beispielsweise auch durch eine Veränderung des Drehmomentes erreicht, mit dem das Aktorgehäuse in das Gehäuse 13 eingeschraubt wird.

Anstelle der beschriebenen Ausführungsform kann der piezoelektrische Aktor beispielsweise auch direkt die Einspritznadel oder ein sonstiges Stellglied betätigen.

Für das Erreichen einer großen Langzeitstabilität der Länge der Keramik 1 hat es sich als vorteilhaft erwiesen, die piezoelektrische Keramik einer Temperaturbehandlung zu unterziehen. Dabei wird die Keramik einer Temperatur im Bereich von 60 bis 200°C für eine vorgegebene Zeitdauer ausgesetzt. Vorzugsweise hat sich eine Zeitdauer im Bereich von 0,5 bis 2,5 Stunden als vorteilhaft erwiesen.

Eine weitere Verbesserung des erfindungsgemäßen Verfahrens wird dadurch erreicht, dass die Temperatur im Bereich von 60°C bis 180°C liegt.

Weiterhin ist es vorteilhaft, die Keramik 1 während der Temperaturbehandlung mechanisch vorzuspannen. Dabei kann die Keramik 1 beispielsweise bereits zwischen die Aktorplatte 16 und die Kopfplatte 18 über die hülsenförmige Rohrfeder 27 eingespannt sein. Es kann jedoch auch jede andere Art von Spannvorrichtung verwendet werden, mit der die zwei Endflächen der Keramik 1 gegeneinander vorgespannt werden.

Weiterhin kann auch die Durchführung des Polungsvorganges während einer mechanischen Vorspannung vorteilhaft sein.

Für die Polung wird eine Spannung verwendet, die vorzugsweise im Bereich von 50 bis 170 V liegt. Bei dem Polungsvorgang mit einer gepulsten Gleichspannung wird die Gleichspannung jeweils für eine festgelegte Zeitdauer angelegt, anschließend für eine weitere Zeitdauer auf 0 Volt erniedrigt und dann wieder die Gleichspannung angelegt.

Die gepulste Gleichspannung wird mit einer Frequenz von 20 bis 120 Hz durchgeführt. Sehr gute Ergebnisse wurden mit einer Frequenz von 100 Hz erreicht.

Ein sehr guter Temperaturbereich liegt zwischen 80 und 100°C. Ebenso ist für eine relativ gute Langzeitstabilität eine Zeitdauer von 1 Stunde für die Temperaturbehandlung ausreichend. Gute Ergebnisse werden auch mit einer Temperatur von 80 bis 130°C erreicht.

Für die Zeitdauer der Polung hat sich ein Zeitbereich von 50 bis 150 Sekunden als vorteilhaft erwiesen. Diese Zeitdauer reicht üblicherweise aus, um eine ausreichende permanente Polarisation der Keramik zu erhalten.

Fig. 5 zeigt ein Diagramm, das einen Spannungsverlauf bei der Polung darstellt. Bei der Polung wird mit einer Anfangsspannung im Bereich von 60 V begonnen, wobei die Spannung mit zunehmender Zeit in Stufen von 1 bis 2 V bis zu einer Maximalspannung von ungefähr 160 V erhöht wird. Diese Erhöhung der Spannung erfolgt in einer Zeitdauer von 60 bis 80 Sekunden. Anschließend wird die Maximalspannung für eine Zeitdauer von 150 bis 170, vorzugsweise 160 Sekunden konstant gehalten. Bei diesem Polungsvorgang wird vorzugsweise eine statische Temperatur eingehalten, die im Bereich von 60 bis 150°C liegt. Nach Beendigung des Polungsvorganges ist eine Verbesserung der Langzeitstabilität der Länge der Keramik 1 erhalten. Der Höhe der Gleichspannung ist vorzugsweise der oben beschriebene Wechsel der gepulsten Spannung überlagert. Damit schwingt die Spannung beim Polungsvorgang zwischen den in Figur 5 dargestellten Größen und dem Nullpunkt hin und her. Vorzugsweise weist die gepulste Gleichspannung eine rechteckförmigen Spannungsverlauf dar, wie in Fig. 5 schematisch dargestellt.

Eine besonders vorteilhafte Ausführungsform des erfindungsgemäßen Verfahrens besteht darin, das Einspritzventil in eine Brennkraftmaschine gemäß Fig. 3 einzubauen und im verbauten Zustand das Einspritzventil in eine Justierphase mit wenigstens einem Parameter zu betreiben, der bei einem Betrieb der Brennkraftmaschine auftritt. Nach der Justierphase wird der piezoelektrische Aktor 17 erneut auf eine festgelegte Lage oder Vorspannung in Bezug auf ein Stellglied 14 justiert. Erst nach dieser Justierphase wird das Einspritzventil zum normalen Betrieb der Brennkraftmaschine verwendet.

Die Brennkraftmaschine, in die das Einspritzventil während der Justierphase eingebaut ist, kann entweder eine spezielle Brennkraftmaschine sein, die nur für Justierphasen verwendet wird, oder es kann auch die Brennkraftmaschine verwendet werden, in der das Einspritzventil im späteren Betrieb eingesetzt werden soll.

Ein wesentlicher Parameter bei der Justierung des Einspritzventils wird durch einen Gegendruck dargestellt, der auf die Keramik bei der Ansteuerung durch das Steuergerät ausgeübt wird. Der Gegendruck kann beispielsweise durch eine entsprechende Vorrichtung oder durch die tatsächliche Situation in der Brennkraftmaschine dargestellt werden. In der Ausführungsform der Fig. 3 und Fig. 4 wird der Gegendruck durch das Stellglied 14 und das Schließglied 20 realisiert. Das Schließglied 20 überträgt den Kraftstoffdruck der Steuerkammer 23 über das Stellglied 14, den Hebel 15 und die Aktorplatte 16 auf die Keramik 1. Auf diese Weise wirkt auf die Keramik 1 ein Druck ein, der auch im üblichen Betrieb der Brennkraftmaschine auftritt. Somit wird auch in bezug auf den Gegendruck eine optimale Justierung erreicht.

Vorzugsweise wird in der Justierphase ein Kraftstoffdruck verwendet, der im oberen, d.h. im Maximalbereich des möglichen Kraftstoffdruckes liegt. Somit wird eine große Belastung der Keramik 1 erreicht und damit ein relativer großer Setzvorgang auf die Keramik 1 ausgeübt. Dies bewirkt, dass die Keramik 1 eine sehr hohe Langzeitstabilität in Bezug auf die Länge aufweist.

Auch bei der Justierphase in der Brennkraftmaschine wird vorzugsweise eine Temperatur auf die Keramik 1 ausgeübt, die im oberen Temperaturbereich der üblicherweise beim Betrieb der Brennkraftmaschine auftretenden Temperaturen liegt. Somit wird auch in Bezug auf die Temperatur eine starke Einwirkung auf die Keramik 1 erreicht. Auch dieser Effekt führt zu einer starken Beanspruchung der Keramik 1 und damit zu einem großen Setzvorgang. Damit wird die Keramik 1 relativ stark verkürzt. Dies bewirkt jedoch eine sehr hohe Langzeitstabilität der Länge der Keramik 1.

Vorzugsweise wird bei der Justierphase die Brennkraftmaschine 6 mit einer hohen Drehzahl betrieben, so dass die Keramik mit einer hohen Frequenz zum Verlängern und Verkürzen angesteuert wird. Damit wird ein starker Setzeffekt auf die Keramik ausgeübt.

## Patentansprüche

1. Verfahren zum Vorbehandeln einer piezoelektrischen Keramik, die zum Einbau in ein Einspritzventil verwendbar ist, wobei die Keramik (1) einer Temperaturbehandlung unterzogen wird, wobei bei der Temperaturbehandlung eine Temperatur von 60°C bis 200°C für eine vorgebbare Zeitdauer eingestellt wird, wobei die Keramik während der Temperaturbehandlung einem Polungsvorgang unterzogen wird, wobei die Polung mit einer gepulsten Gleichspannung durchgeführt wird,
**dadurch gekennzeichnet, dass**
die Spannung von einem Anfangswert mit zunehmender Zeit auf einen Maximalwert erhöht wird, und dass die maximale Spannung für eine festgelegte Zeitdauer konstant gehalten wird..

2. Verfahren nach Anspruch 1, **dadurch gekennzeichnet, dass** die vorgebbare Zeitdauer bei der Temperaturbehandlung zwischen 0,5 und 2,5 Stunden beträgt.

3. Verfahren nach einem der Ansprüche 1 oder 2, **dadurch gekennzeichnet, dass** die Temperatur im Bereich von 60°C bis 180°C liegt.

4. Verfahren nach einem der Ansprüche 1 bis 3, **dadurch gekennzeichnet, dass** die Keramik (1) während der Temperaturbehandlung mechanisch vorgespannt wird.

5. Verfahren nach Anspruch 1, **dadurch gekennzeichnet, dass** die Polung mit einer Spannung von 50 bis 170 Volt durchgeführt wird.

6. Verfahren nach Anspruch 5, **dadurch gekennzeichnet, dass** die Polung mit einer Frequenz von 20 bis 120 Hz durchgeführt wird.

7. Verfahren nach einem der Ansprüche 1 bis 6, **dadurch gekennzeichnet, dass** die Polung über eine Zeit von 50 bis 150 Sekunden durchgeführt wird.

8. Verfahren zum Justieren eines Einspritzventils, wobei das Einspritzventil einen piezoelektrischen Aktor aufweist, wobei der Aktor eine definierte Lage oder Vorspannung in bezug auf ein Stellglied des Einspritzventils aufweist,
**dadurch gekennzeichnet,**
**dass** das Einspritzventil (7) in einer Justierphase wenigstens mit einem Parameter betrieben wird, der beim Betrieb in einer Brennkraftmaschine (6) auftritt,
**dass** nach der Justierphase der Aktor (17) auf eine definierte Lage oder Vorspannung eingestellt wird, und dass der piezoelektrische Aktor gemäß dem Verfahren nach Anspruch 1 vorbehandelt wird.

9. Verfahren nach Anspruch 8, **dadurch gekennzeichnet, dass** das Einspritzventil (7) in einer Brennkraftmaschine (6) eingebaut ist,
dass das Einspritzventil (7) in der Justierphase zum Einspritzen von Kraftstoff verwendet wird.

10. Verfahren nach Anspruch 8 oder 9, **dadurch gekennzeichnet, dass** das Einspritzventil (7) mit einem Kraftstoffspeicher (9) in Verbindung steht, dass der Kraftstoffspeicher (9) Kraftstoff mit einem vorgebbaren Druck zum Einspritzen bereithält, dass der Druck vorzugsweise in einem Bereich liegt, der beim Betrieb der Brennkraftmaschine (6) einem Maximalbereich entspricht.

11. Verfahren nach einem der Ansprüche 8 bis 10, **dadurch gekennzeichnet, dass** der Aktor (17) für das Einspritzen von Kraftstoff mit einer hohen Frequenz angesteuert wird, die einer hohen Drehzahl der Brennkraftmaschine (6) entspricht.

12. Verfahren nach einem der Ansprüche 8 bis 11, **dadurch gekennzeichnet, dass** die Brennkraftmaschine (6) mit einer Temperatur, insbesondere im Bereich der Keramik (1) betrieben wird, die im mittleren bis oberen Temperaturbereich der im Betrieb der Brennkraftmaschine auftretenden Temperaturen liegt.

## Claims

1. Method for pre-treating a piezoelectric ceramic which can be used for fitment in an injection valve in which case the ceramic (1) is subjected to a temperature treatment in which case for the temperature treatment a temperature ranging from 60°C to 200°C is set for a period in time which can be predetermined in which case the ceramic is subjected to a polarity process while said ceramic is subjected to a temperature treatment in which case the polarity is set with a pulsed direct voltage,
**characterized in that**
the voltage is raised from an initial value with increasing time to a maximum value and that the maximum voltage is kept constant for a specified period in time.

2. Method in accordance with claim 1, **characterized in that** the period in time which can be predetermined for the temperature treatment is between 0.5 and 2.5 hours.

3. Method in accordance with one of the claims 1 or 2, **characterized in that** the temperature lies in the range from 60°C to 180°C.

4. Method in accordance with one of the claims 1 to 3, **characterized in that** the ceramic (1) is subjected to a mechanical pre-stress while said ceramic is subjected to a temperature treatment.

5. Method in accordance with claim 1, **characterized in that** the polarity is carried out with a voltage ranging from 50 to 170 V.

6. Method in accordance with claim 5, **characterized in that** the polarity is carried out with a frequency ranging from 20 to 120 Hz.

7. Method in accordance with one of the claims 1 to 6, **characterized in that** the polarity is carried out over a period in time ranging from 50 to 150 seconds.

8. Method for adjusting an injection valve in which case the injection valve has a piezoelectric actuator in which case the actuator has a defined position or pre-stress with regard to a final control element of the injection valve, **characterized in that**
the injection valve (7) in an adjusting phase is at least operated with one parameter which occurs during normal operation of the internal combustion engine (6),
that after the adjusting phase the actuator (17) is adjusted to a defined position or pre-stress and that the piezoelectric actuator is pre-treated in accordance with the method in accordance with claim 1.

9. Method in accordance with claim 8, **characterized in that** the injection valve (7) is fitted in an internal combustion engine (6),
and the injection valve (7) is used in the adjusting phase for the injection of fuel.

10. Method in accordance with claim 8 or 9, **characterized in that** the injection valve (7) is connected to a fuel accumulator (9), that the fuel accumulator (9) holds ready the fuel at a pressure which can be predetermined for injection and that the pressure preferably lies in a range which conforms to a maximum range during the operation of the internal combustion engine (6).

11. Method in accordance with one of the claims 8 to 10, **characterized in that** the actuator (17) for the injection of fuel is activated with a high frequency which conforms to a high rotational speed of the internal combustion engine (6).

12. Method in accordance with one of the claims 8 to 11, **characterized in that** the internal combustion engine (6) is operated at a temperature, which in particular in the area of the piezoelectric ceramic (1) lies in the middle to upper temperature range, which can occur during the operation of the internal combustion engine.

## Revendications

1. Procédé permettant le prétraitement d'une céramique piézoélectrique pouvant être utilisée pour être montée dans une soupape injectrice, la céramique (1) étant soumise à un traitement thermique, une température comprise entre 60°C et 200°C étant réglée, lors dudit traitement thermique, pour une durée préalablement définissable, la céramique étant soumise pendant le traitement thermique à un processus de polarisation, la polarisation étant réalisée avec une tension continue pulsée, **caractérisé en ce qu'**on augmente la tension en la faisant progressivement passer d'une valeur initiale à une valeur maximale, et **en ce que** la tension maximale est maintenue constante pendant une durée déterminée.

2. Procédé selon la revendication 1, **caractérisé en ce que** la durée préalablement définissable du traitement thermique est comprise entre 0,5 et 2,5 heures.

3. Procédé selon l'une des revendications 1 ou 2, **caractérisé en ce que** la température se situe dans une plage comprise entre 60°C et 180°C.

4. Procédé selon l'une des revendications 1 à 3, **caractérisé en ce que** la céramique (1) est précontrainte de manière mécanique pendant le traitement thermique.

5. Procédé selon la revendication 1, **caractérisé en ce que** la polarisation est réalisée avec une tension comprise entre 50 et 170 volts.

6. Procédé selon la revendication 5, **caractérisé en ce que** la polarisation est réalisée avec une fréquence comprise entre 20 et 120 Hz.

7. Procédé selon l'une des revendications 1 à 6, **caractérisé en ce que** la polarisation est réalisée sur une période comprise entre 50 et 150 secondes.

8. Procédé permettant l'ajustage d'une soupape injectrice, la soupape injectrice présentant un actionneur piézoélectrique, l'actionneur présentant une position ou précontrainte définie par rapport à un organe de réglage de la soupape injectrice, **caractérisé en ce que**
dans une phase d'ajustage, on fait fonctionner la soupape injectrice (7) avec au moins un paramètre qui apparaît lors de son fonctionnement dans un moteur à combustion interne (6),
après la phase d'ajustage, l'actionneur (17) est ajusté à une position ou précontrainte définie, et que
l'actionneur piézoélectrique est prétraité conformément au procédé selon la revendication 1.

9. Procédé selon la revendication 8, **caractérisé en ce que**
la soupape injectrice (7) est montée dans un monteur à combustion interne (6),
la soupape injectrice (7) est utilisée dans la phase d'ajustage pour l'injection de carburant.

10. Procédé selon la revendication 8 ou 9, **caractérisé en ce que** la soupape injectrice (7) est reliée à un accumulateur de carburant (9), que l'accumulateur de carburant (9) fournit, pour l'injection, du carburant présentant une pression préalablement définissable, que ladite pression se situe de préférence dans une zone qui correspond, lors du fonctionnement du moteur à combustion interne (6), à une zone maximale.

11. Procédé selon l'une des revendications 8 à 10, **caractérisé en ce que** l'actionneur (17) est activé, pour l'injection de carburant, avec une fréquence élevée qui correspond à un nombre de tours élevé du moteur à combustion interne (6).

12. Procédé selon l'une des revendications 8 à 11, **caractérisé en ce que** l'on fait fonctionner le moteur à combustion interne (6), notamment dans la zone de la céramique (1), avec une température qui se situe dans la plage entre les températures moyennes et les températures supérieures apparaissant lors du fonctionnement du moteur à combustion interne.
